# EUROPÄISCHE PATENTANMELDUNG

(11) **EP 2 278 596 A2**
(43) Veröffentlichungstag der Anmeldung: **26.01.2011**
(21) Anmeldenummer: 10006266.0
(22) Anmeldetag: 17.06.2010
(51) Int. Cl.: H01C 10/10

(54) **Verfahren zu Herstellung und Ansteuerung eines regelbaren Widerstandsbauelement und dessen Verwendung**

(30) Priorität: 25.07.2009 DE 102009034777
(71) Anmelder: SEMIKRON Elektronik GmbH & Co. KG, 90431 Nürnberg (DE)
(72) Erfinder: Berberich, Sven, 91080 Spardorf (DE); Stockmeier, Thomas, 91054 Erlangen (DE)

(57) **Zusammenfassung**

Die Erfindung beschreibt Verfahren zu Herstellung und Ansteuerung eines regelbaren Widerstandsbauelements mit einem Widerstandsgrundkörper und einem Aktor, wobei der Widerstandsgrundkörper aus einem Halbleitermaterial besteht und zur stoffschlüssigen Verbindung eine Verbindungsfläche zur Anordnung des Aktors vorgesehen ist. Hierbei weist der Aktor zur elektrischen Verbindung mindesten zwei zweite Kontaktflächen auf womit durch Anlegen einer Spannung durch den Aktor über die Verbindungsfläche mechanisch Kraft auf den Widerstandsgrundkörper eingeleitet wird, wodurch sich der Widerstandswert des Widerstandsgrundkörpers verändert. Dieser regelbare Widerstand wird in einer Schaltungsanordnung zur Ansteuerung eines Leistungshalbleiterschalters verwendet, wobei ein Ansteuersignal von der Treiberschaltung über den regelbaren Widerstand an den Steuereingang des Leistungshalbleiterschalters angelegt wird und der Widerstandswert des regelbaren Widerstandsbauelements von der Treiberschaltung geregelt wird.

## Beschreibung

### Beschreibung

Die Erfindung beschreibt ein Verfahren zur Herstellung und Betrieb eines regelbares Widerstandsbauelements, dessen Widerstandswert im Betrieb durch eine elektrische Stellgröße verändert, geregelt werden kann. Die Geschwindigkeit dieser Regelung soll zumindest im Bereich von einigen Kilohertz liegen, da eine wesentliche Verwendung dieses regelbaren Widerstandsbauelements in der Ansteuerung von Leistungshalbleiterschaltern liegt.

Derartige Leistungshalbleiterschalter wie sie in einer Vielzahl von leistungselektronischen Schaltungen Anwendung finden, werden häufig durch Lade- bzw. Entladevorgänge eines Steueranschlusses (Gate) geschaltet. Aktuelle Anwendungen derartiger Leistungshalbleiterschalter weisen im Rahmen von Pulswellenmodulationsverfahren eine Abfolge von Ansteuersignalen im Bereich von mehr als einem Kilohertz auf.

Aus dem Stand der Technik allgemein bekannt sind Schaltungsanordnungen mit einer Treiberschaltung und mindestens einem Leistungshalbleiterschalter, wobei zwischen der Treiberschaltung und dem Steueranschluss des jeweiligen Leistungshalbleiterschalters zwei Strompfade vorgesehen sind mit je einem Widerstand für den Ein- und Ausschaltimpuls. Dies ist bevorzugt, da die Anforderungen an den Spannungs- und Stromverlauf beim Einschalten sich von denen beim Ausschalten unterscheiden.

Der vorliegenden Erfindung liegt die Aufgabe zu Grunde ein Verfahren zu Herstellung und Ansteuerung eines regelbaren Widerstandsbauelements vorzustellen das Schalt-, bzw. Regelgeschwindigkeiten im Bereich von mehr als einem Kilohertz aufweist und das in einer Schaltungsanordnung zur Ansteuerung eines Leistungshalbleiterschalters Verwendung findet.

Diese Aufgabe wird gelöst durch Verfahren gemäß dem Anspruch 1 und eine Verwendung gemäß Anspruch 7, wobei spezielle Ausgestaltungen in den jeweiligen abhängigen Ansprüchen genannt sind.

Die Grundlage des erfindungsgemäß hergestellten regelbaren Widerstandsbauelements bildet ein Widerstandsgrundkörper aus einem Halbleitermaterial, vorzugsweise p-dotiertem Silizium. Weiterhin ist es besonders bevorzugt wenn der Widerstandsgrundkörper aus einer Schichtanordnung eines ersten Teilkörpers geringer Dotierung und eines zweiten Teilkörpers höherer Dotierung besteht. Bei geeigneter Wahl der Dotierung weist dann der zweite Teilkörper einen Widerstandswert auf, der mindestens drei Größenordnungen unter demjenigen des ersten Teilkörpers liegt. Somit trägt zur effektiven Stromleitung in dem Widerstandsgrundkörper signifikant nur der zweite Teilkörper bei.

Grundsätzlich ist es bekannt, dass der Widerstand von Halbleitermaterial von der Ladungstägerbeweglichkeit abhängt. Eine Einflussgröße für diese Ladungsträgerbeweglichkeit ist die Einwirkung von Zug oder Druck in eine geeignete Richtung des Kristallgitters. Beispielhaft ist es bei geeignet p-dotiertem Silizium möglich bei Einwirkung in <100> oder <110> Orientierung des Kristallgitters und einer Stauchung oder Dehnung von 1% der Ausdehnung die Ladungstägerbeweglichkeit der Löcher um ca. einen Faktor zu erhöhen. Es hat sich hierzu als vorteilhaft erwiesen die Dotierungskonzentration des ersten Teilkörpers mit ca. 1x10¹²cm⁻³ vorzusehen, während die Dotierungskonzentration des zweiten Teilkörpers mit ca. 1x10¹⁹cm⁻³ vorzusehen ist.

Zur Ausübung der beschriebenen Krafteinwirkung ist erfindungsgemäß mindestens ein elektrisch ansteuerbarer Aktor vorgesehen, der vorzugsweise den inversen Piezoeffekt zur Ausführung der Bewegung vorsieht. Derartige Aktoren sind grundsätzlich in Form von verschiedenen Kristallen bekannt. Ebenso bekannt sind auch Aktoren aus Werkstoffen, beispielhaft Zinkoxyd, die durch Schichtwachstum auf Silizium hergestellt werden können.

Beiden genannten wie allen weiteren Ausgestaltungen ist es gemeinsam, dass der Aktor zur Einleitung einer Kraft zu dem Widerstandsgrundkörper, insbesondere zu einem zweiten Teilkörper, stoffschlüssig mit einer Verbindungsfläche, die zumindest teilweise parallel zu einer ersten Hauptfläche des Widerstandsgrundkörpers ist, angeordnet ist. Somit kann elektrisch angesteuert eine mechanische Kraft auf diesen Widerstandsgrundkörper einwirken und dessen Widerstandswert verändern.

Selbstverständlich weist der Widerstandsgrundkörper, vorzugsweise der zweite Teilkörper, erste Kontaktflächen auf zur Ausbildung einer elektrischen Verbindung. Ebenso weist der Aktor zweite Kontaktfläche zu seiner elektrischen Verbindung auf.

Durch Anlegen einer geeigneten Spannung, vorzugsweise in der Größenordnung von 10V, expandiert oder kontrahiert der Aktor, wobei je nach dessen Anordnung zum Widerstandsgrundkörper auf diesen eine mechanische Kraft mit einer Hauptwirkrichtung parallel oder senkrecht zu dessen erster Hauptfläche eingeleitet wird. Bei einer Hauptwirkrichtung senkrecht zur ersten Hauptfläche ist es bevorzugt, wenn der Aktor sich zur Krafteinleitung gegen ein Widerlager abstützen kann. Hierfür bietet sich beispielhaft ein Gehäuse um den regelbaren Widerstand an.

Diese Hauptwirkrichtung der mechanischen Kraft senkrecht zur ersten Hauptfläche des Widerstandsgrundkörpers hat speziell bei Ausgestaltung als Schichtfolge aus einem ersten und einem zweiten Teilkörper den Vorteil, dass die mechanische Kraft gleichmäßig auf das vom Aktor überdeckte Volumen des für die Stromleitung maßgeblichen zweiten Teilkörpers einwirkt.

Bei einem planaren Schichtaufbau hat eine Hauptwirkrichtung der mechanischen Kraft parallel zur ersten Hauptfläche des Widerstandsgrundkörpers den wesentlichen Vorteil, dass ein Widerlager in oben genanntem Sinn entfallen kann. Allerdings wirkt hierbei die mechanische Kraft nicht gleichmäßig auf das vom Aktor überdeckte Volumen ein.

In einer weiteren vorteilhaften Ausgestaltung bildet der Widerstandsgrundkörper eine Wanne aus, deren Oberfläche zumindest teilweise als Verbindungsfläche mit dem Aktor dient, wobei der Aktor zumindest teilweise in dieser Wanne angeordnet ist.

Durch diese genannte Ausbildung und Ansteuerung entsteht ein regelbares Widerstandsbauelement, dessen Widerstandswert um mindestens einen Faktor zwei, bei geeigneter Ausbildung aber auch um mindestens eine Größenordnung, durch anlegen einer elektrischen Spannung geändert werden kann, wobei die Widerstandswerte bei oben genannter Ausbildung der Dotierung im Bereich von einigen bis einigen zehn Ohm liegen. Zudem ist es durch die Verwendung geeigneter Aktoren unter Ausnutzung des inversen Piezoeffekts möglich derartige Änderungen des Widerstandswertes mit einer Frequenz von deutlich mehr als einem Kilohertz vorzunehmen.

Das erfindungsgemäß hergestellte und angesteuerte regelbare Widerstandsbauelement findet erfindungsgemäß Verwendung bei der Ansteuerung eines Leistungshalbleiterschalters. Die Schaltungsanordnung weist hier eine Treiberschaltung auf, dessen Steuerausgang über das regelbare Widerstandsbauelement mit dem Steuereingang des Leistungshalbleiterschalters verbunden ist.

Zum Ein- bzw. Ausschalten des Leistungshalbleiterschalters legt die Treiberschaltung ein Ansteuersignal über den regelbaren Widerstand an den Steuereingang des Leistungshalbleiterschalters an. Zumindest bei einem der beiden Schaltvorgänge regelt die Treiberschaltung den Widerstandswert des regelbaren Widerstandsbauelements um damit den gewünschten Strom- und Spannungsverlauf während der Schaltvorgangs einzustellen.

Hierbei kann es bevorzugt sein für das Ansteuersignal zum Einschalten des Leistungshalbleiterschalters einen ersten konstanten Widerstandswert am regelbaren Widerstand einzustellen und für das Ansteuersignal zum Ausschalten des Leistungshalbleiterschalters einen zweiten konstanten Widerstandswert am regelbaren Widerstand einzustellen. Typischerweise unterscheiden sich diese beiden Widerstandswerte um mindestens den Faktor 2. Allerdings kann es auch bevorzugt sein, wenn einer der beiden Widerstandswerte demjenigen Widerstandswert ohne angelegte Spannung entspricht.

Eine weitere bevorzugte Ausgestaltung der Verwendung zur Ansteuerung eines Leistungshalbleiterschalters weist zumindest für eines der Ansteuersignale zum Ein- oder Ausschalten des Leistungshalbleiterschalters einen während der Dauer des jeweiligen Ansteuersignals variablen Widerstandswert am regelbaren Widerstand auf, der von der Treiberschaltung entsprechend geregelt wird. Hierbei kann dieser Widerstandswert im einfachsten Fall abhängig von der aktuellen Spannung des Ansteuersignals gewählt werden.

Die Erfindung wird anhand von Ausführungsbeispielen in Verbindung mit den Fig. 1 bis 3 näher erläutert.

Fig. 1 zeigt eine erste Ausführungsform eines erfindungsgemäß hergestellten regelbaren Widerstandsbauelements.

Fig. 2 zeigt eine zweite Ausführungsform eines erfindungsgemäß hergestellten regelbaren Widerstandsbauelements.

Fig. 3 zeigt eine Abwandlung der zweiten Ausführungsform.

Fig. 4 zeigt eine Schaltungsanordnung gemäß dem Stand der Technik zur Ansteuerung eines Leistungshalbleiterschalters.

Fig. 5 zeigt eine Schaltungsanordnung zum erfindungsgemäßen Ansteuern eines Leistungshalbleiterschalters.

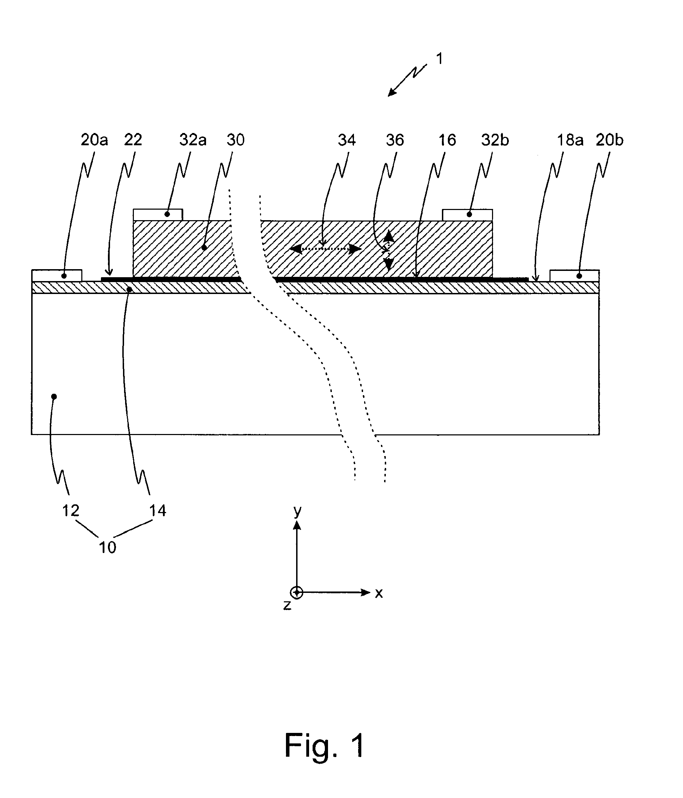

Fig. 1 zeigt ein erfindungsgemäß hergestelltes regelbares Widerstandsbauelement (1). Dargestellt ist der quaderförmige Widerstandsgrundkörper (10) mit einer typischen Längenausdehnung (x-Richtung) von 6mm einer Breite (z-Richtung) von 2mm und eine Höhe (y-Richtung) von 500µm. Dieser ist als planare Schichtanordnung eines ersten (12) und eines zweiten (14) Teilkörpers ausgebildet. Hierbei weist der erste Teilkörper (12) eine Höhe von 499,8µm und eine p-Dotierung von 1x10¹²cm⁻³ auf, während der zweite Teilkörper (14) eine Höhe von 200nm und ein p-Dotierung von 1x10¹⁹cm⁻³ aufweist.

Durch diese Ausbildung trägt der erste Teilkörper (12) zur elektrischen Längsleitung nicht wesentlich bei, da er einen Widerstandswert in der Größenordnung von 1 MOhm aufweist, während der zweite Teilkörper (14) einen Widerstandswert in der Größenordnung 100hm aufweist. Daher sind die ersten Kontaktflächen (20 a/b) zur elektrischen Verbindung des Widerstandsgrundkörpers (10) auf dessen erster dem zweiten Teilkörper (14) zugeordneten ersten Hauptfläche (18a) vorgesehen.

Ebenfalls auf der ersten Oberfläche (16) und durch eine Isolationsschicht (22) von diesem elektrisch isoliert ist der Aktor (30), ein Piezobauelement, angeordnet. Zur Verbindung der Piezobauelements (30) mit der Verbindungsfläche (16) bzw. hier der Isolationsschicht (22) ist eine dauerhafte stoffschlüssige Verbindung vorteilhaft, da hierüber mechanisch Kraft auf den Widerstandsgrundkörper (10) eingeleitet wird. Als stoffschlüssige Verbindungen haben sich Sinterverbindungen besonders bewährt, es sind aber auch Klebeoder Lötverbindungen einsetzbar. Besonders bevorzugt kann es sein durch Schichtwachstum das Piezobauelement (30) direkt auf dem Siliziumkörper des Widerstandsgrundkörpers (10) aufwachsen zu lassen. Derartige Verbindungen weisen eine besonders lange Lebensdauer auf. Es kann weiterhin bevorzugt sein das Piezobauelement (30) durch Aneinanderreihung einzelner Bauelemente auszubilden, da hierdurch der Arbeitshub erhöht wird. Unter Arbeitshub soll hierbei die maximale relative Längenänderung des Piezobauelements (30) verstanden werden.

In dieser Ausgestaltung weist das Piezobauelement (30) eigene zweite Kontaktflächen (32 a/b) auf zu dessen elektrischer Ansteuerung, wodurch das regelbare Widerstandsbauelement (1) einen 4-Pol ausbildet. Es kann allerdings auch vorteilhaft sein, wenn das regelbare Widerstandsbauelement (1) einen 3-Pol ausbildet und hierbei eine der beiden zweiten Kontaktflächen (32 a/b) eine elektrische Verbindung mit dem Widerstandsgrundkörper (10) , hier insbesondere dem zweiten Teilkörper (14) , aufweist.

Eine Änderung des Widerstandswertes wird nun dadurch erreicht, indem an das Piezobauelemente (30) eine Spannung angelegt wird und hierdurch mechanisch Kraft auf den Widerstandsgrundkörper (10), hier insbesondere auf den zweiten Teilkörper (14), eingeleitet wird. Wesentlich ist hierbei die Anordnung des Piezobauelements (30), von der dessen Hauptwirkrichtung abhängt. Abhängig vom Anwendungsfall und damit von der notwendigen Änderung des Widerstandswertes kann es bevorzugt sein die Hauptwirkrichtung senkrecht (36) oder parallel (34) zur ersten Oberfläche (16) zu wählen. Unter Hauptwirkrichtung wird hier diejenige Dimension in x- oder y-Richtung verstanden, die den größten Arbeitshub aufweist.

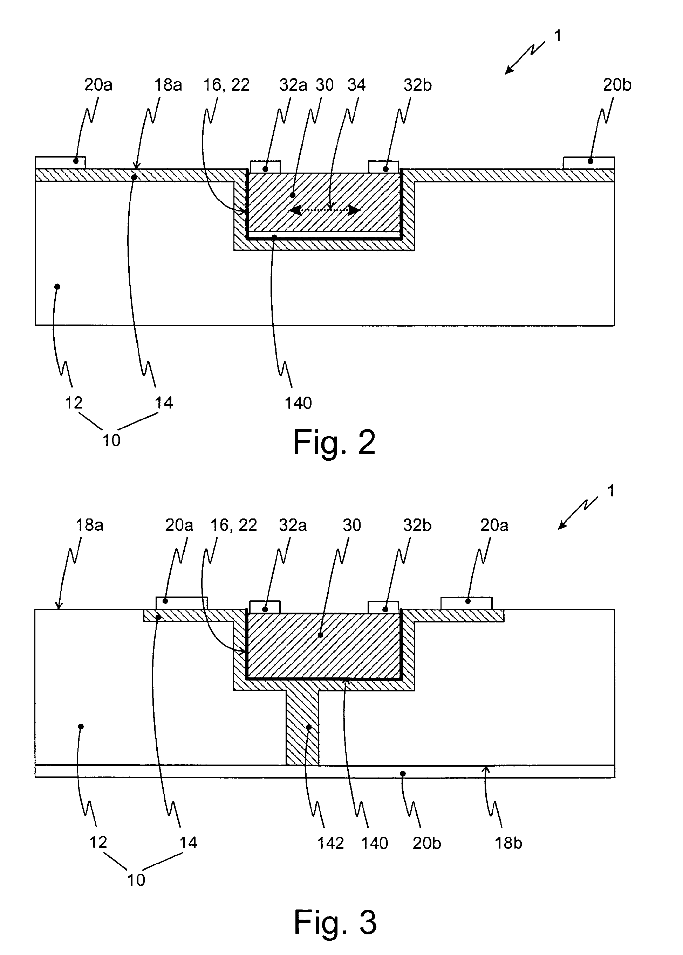

Fig. 2 zeigt eine zweite Ausführungsform eines erfindungsgemäß hergestellten regelbaren Widerstandsbauelements (1). Die Grundelemente dieser Ausführungsform sind identisch denjenigen der ersten Ausführungsform. Allerdings weist der Widerstandsgrundköper (10) hier eine Wanne (140) auf, deren Oberfläche teilweise die Kontaktfläche (16) mit dem Piezobauelement (30) bildet und hier vorteilhafterweise ebenfalls eine Isolationsschicht (22) aufweist. Das Piezobauelement (30) ist hierbei zumindest teilweise, vorteilhafterweise aber vollständig in dieser Wanne (140) des Widerstandsgrundkörpers (10) angeordnet, wobei ein Kontakt mit allen Teilflächen der Wanne (140) nicht notwendig ist.

Der wesentliche Vorteil dieser Ausführungsform liegt darin, dass die mechanische Kraft mit einer Hauptwirkrichtung parallel (34) zur ersten Haupifläche (18a) senkrecht auf den entsprechenden Abschnitt des zweiten Teilkörpers (14) einwirkt, ohne dass ein zusätzliches Widerlager notwendig ist.

Fig. 3 zeigt eine Abwandlung der zweiten Ausführungsform. Hierbei sind der erste (12) und zweite Teilkörper (14) des Widerstandsgrundkörpers (10) derart ausgebildet, dass sich eine Wanne (140) bildet und von dieser ausgehend ein Kanal (142) höherer Dotierung zur zweiten Hauptfläche (18b) des Widerstandsgrundkörpers (10) vorgesehen ist. Eine der beiden ersten Kontaktflächen (20a) kann hier umlaufend um diese Wanne (140) ausgebildet sein, während die andere erste Kontaktfläche (20b) vorteilhafterweise auf der gegenüberliegenden zweiten Hauptfläche (18b) derart angeordnet ist, dass sie zumindest annährend die gesamte zweite Hauptfläche (18b) bedeckt.

Durch eine Anordnung einer Mehrzahl derartiger Aktoren (30), wie sie in den vorhergehenden Ausführungsbeispielen beschrieben sind zu einem Widerstandsgrundkörper (10) wird der Regelbereich des Widerstandsbauelements (1) erweitert und / oder in seine Dosierbarkeit verbessert.

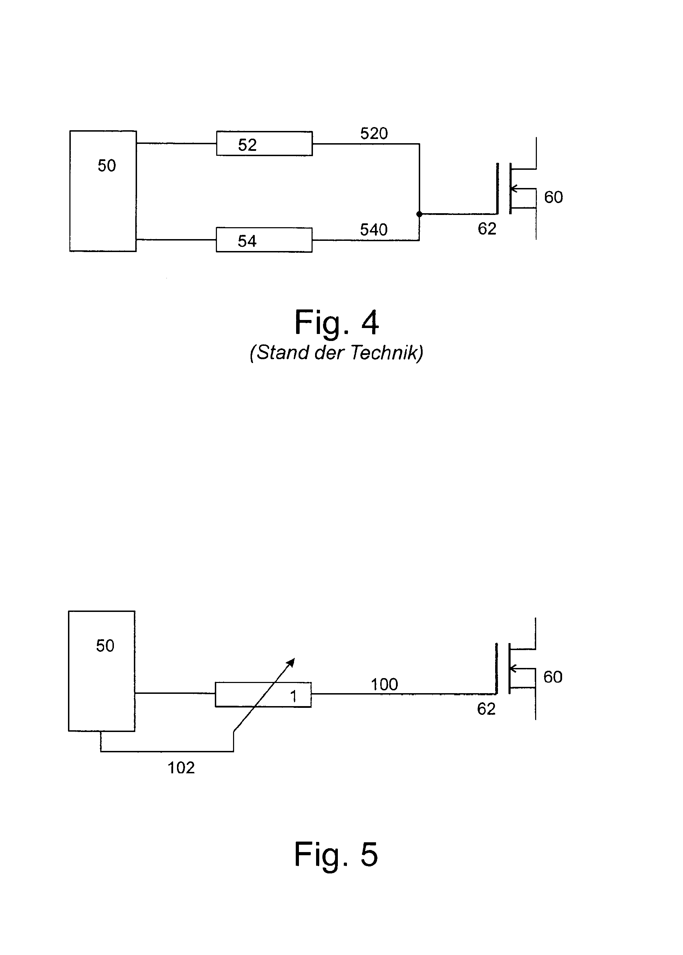

Fig. 4 zeigt eine Schaltungsanordnung gemäß dem Stand der Technik zur Ansteuerung eines Leistungshalbleiterschalters (60). Dargestellt ist eine Treiberschaltung (50) sowie ein erster (520) und zweiter (540) Strompfad zum Steueranschluss (62) eines Leistungshalbleiterschalters (60), beispielhaft ein IGBT oder ein MOS-FET. Im ersten Strompfad (520), demjenigen des Einschaltsignals ist ein erster Widerstand (52) mit einem ersten Widerstandswert angeordnet, während analog im zweiten Strompfand (540) demjenigen des Abschaltsignals ein zweiter Widerstand (54) mit einem zweiten Widerstandswert angeordnet ist.

Gemäß dem Stand der Technik unterscheiden sich die beiden Widerstandswerte des ersten (52) und zweiten (54) Widerstands um mindesten einen Faktor 2 und liegen bei der Ansteuerung von einzelnen Leistungshalbleiterschaltern (60) in der Größenordnung von 100hm.

Fig. 5 zeigt eine Schaltungsanordnung zum erfindungsgemäßen Ansteuern eines Leistungshalbleiterschalters (60). Diese unterscheidet sich vom Stand der Technik gemäß Fig. 2 durch nur einen Strompfad (100) von der Treiberschaltung (50) zum Leistungshalbleiterschalter (60). Der Widerstand in diesem Strompfad ist ein regelbares Widerstandsbauelement (1), wie unter Fig. 1 beschrieben. Weiterhin weist die Schaltungsanordnung einen Regelpfad (102) von der Treiberschaltung (50) zum regelbaren Widerstandsbauelement (1) auf um dessen Widerstandswert regeln zu können.

Im einfachsten Fall wird in einem der beiden Schaltzustände, dem Ein- oder Ausschalten des Leistungshalbleiterschalters (60) die Regelung nicht eingreifen und den Grundwert des regelbaren Widerstandsbauelements (1) von beispielhaft 40V unverändert lassen. Im jeweils anderen Fall wird der Widerstandswert durch anlegen einer Spannung im Bereich von 10V an den regelbaren Widerstand (1) dessen Widerstandswert auf 10V gesenkt. Somit ist eine funktional analoge Ausgestaltung zum unter Fig. 2 beschriebenen Stand der Technik ausgebildet.

Die hohe Regelgeschwindigkeit auf Grund des Piezobauelements (30) erlaubt darüber hinaus auch eine Änderung des Widerstandswertes während der Dauer eines Ansteuersignals die Änderung des Widerstandswertes des regelbaren Widerstandsbauelements (1). Hierdurch ist gegenüber dem Stand der Technik eine wesentlich flexiblerer Ansteuerung des Leistungshalbleiterschalters (60) möglich.

## Patentansprüche

1. Verfahren zu Herstellung und Ansteuerung eines regelbaren Widerstandsbauelement (1) mit einem Widerstandsgrundkörper (10) und mindestens einem Aktor (30), wobei der Widerstandsgrundkörper (10) aus einem Halbleitermaterial besteht, zur elektrischen Verbindung mindestens zwei erste Kontaktflächen (20 a/b) und zur stoffschlüssigen Verbindung eine Verbindungsfläche (16) zur Anordnung des Aktors (30) vorgesehen ist, wobei der Aktor (30) zur elektrischen Verbindung mindesten zwei zweite Kontaktflächen (32 a/b) aufweist und durch Anlegen einer Spannung an diese zweiten Kontaktflächen (32 a/b) durch den Aktor (30) über die Verbindungsfläche (16) mechanisch Kraft auf den Widerstandsgrundkörper (10) eingeleitet wird, deren Hauptwirkrichtung parallel (34) oder senkrecht (36) zur ersten Hauptfläche (18a) verläuft, wodurch sich der Widerstandswert des Widerstandsgrundkörpers (10) verändert.

2. Verfahren nach Anspruch 1, wobei
die stoffschlüssige Verbindung zwischen der Verbindungsfläche (16) des Widerstandsgrundkörpers und dem Aktor (30) mittels einer Klebe-, Löt- oder Sinterverbindung hergestellt wird.

3. Verfahren nach Anspruch 1, wobei
die stoffschlüssige Verbindung zwischen der Verbindungsfläche (16) des Widerstandsgrundkörpers (10) und dem Aktor (30) mittels geregelten Schichtwachstums hergestellt wird.

4. Verfahren nach Anspruch 1, wobei
der Aktor (30) zur Ausübung der mechanischen Bewegung den inversen Piezoeffekt ausnutzt.

5. Verfahren nach Anspruch 1, wobei
der Widerstandsgrundkörper (10) aus einer Schichtanordnung eines ersten Teilkörpers (12) geringer Dotierung und eines zweiten Teilkörpers (14) höherer Dotierung besteht, wodurch dieser einen Widerstandswert aufweist, der mindestens drei Größenordnungen unter demjenigen des ersten Teilkörpers (12) liegt und sowohl die ersten Kontaktflächen (20 a/b) wie auch die Verbindungsfläche (16) an dem zweiten Teilkörper (14) angeordnet sind.

6. Verfahren nach Anspruch 1 oder 5, wobei
der Widerstandsgrundkörper (10) mindestens eine Wanne (140) ausbildet und der jeweilige Aktor (30) zumindest teilweise in einer derartigen Wanne (140) angeordnet ist.

7. Verwendung eines regelbaren Widerstandsbauelements (1) bestehend aus einem Widerstandsgrundkörper(10) und einem hiermit stoffschlüssig verbunden Aktor (30) in einer Schaltungsanordnung zur Ansteuerung eines Leistungshalbleiterschalters (60) mit einer Treiberschaltung (50), wobei ein Ansteuersignal von der Treiberschaltung über den regelbaren Widerstand (1) an den Steuereingang (62) des Leistungshalbleiterschalters (60) angelegt wird und der Widerstandswert des regelbaren Widerstandsbauelements (1) von der Treiberschaltung geregelt wird.

8. Verwendung nach Anspruch 7, wobei
für das Ansteuersignal zum Einschalten des Leistungshalbleiterschalters (60) ein erster konstanter Widerstandswert am regelbaren Widerstandsbauelement (1) eingestellt wird und für das Ansteuersignal zum Ausschalten des Leistungshalbleiterschalters (60) ein zweiter konstanter Widerstandswert am regelbaren Widerstandsbauelement (1) eingestellt wird, der um mindestens den Faktor 2 größer oder kleiner demjenigen zum Einschalten ist.

9. Verwendung nach Anspruch 7, wobei
für das jeweilige Ansteuersignal zu Ein- oder Ausschalten des Leistungshalbleiterschalters (60) ein während der Dauer des jeweiligen Ansteuersignales variabler Widerstandswert am regelbaren Widerstandsbauelement (1) eingestellt wird.

10. Verwendung nach Anspruch 10, wobei
der Widerstandswert abhängig von der Spannung des Ansteuersignales gewählt wird.
